(19) **Europäisches Patentamt / European Patent Office / Office européen des brevets**

(11) **EP 3 066 484 B1**

(12) **FASCICULE DE BREVET EUROPEEN**

(45) Date de publication et mention de la délivrance du brevet:
**06.12.2017 Bulletin 2017/49**

(21) Numéro de dépôt: **14806002.3**

(22) Date de dépôt: **04.11.2014**

(51) Int Cl.:
*G01R 35/00* (2006.01)     *G01R 29/12* (2006.01)

(86) Numéro de dépôt international:
**PCT/FR2014/052801**

(87) Numéro de publication internationale:
**WO 2015/067884 (14.05.2015 Gazette 2015/19)**

(54) **CALIBRATION D'UN DISPOSITIF DE MESURE D'UN CHAMP ELECTRIQUE EN MILIEU CONDUCTEUR**

KALIBRIERUNG EINER VORRICHTUNG ZUR MESSUNG EINES ELEKTRISCHEN FELDS IN EINEM LEITENDEN MEDIUM

CALIBRATION OF A DEVICE FOR MEASURING AN ELECTRIC FIELD IN A CONDUCTING MEDIUM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **07.11.2013 FR 1360900**

(43) Date de publication de la demande:
**14.09.2016 Bulletin 2016/37**

(73) Titulaires:
- **Commissariat à l'Energie Atomique et aux Energies Alternatives**
  **75015 Paris (FR)**
  Etats contractants désignés:
  **AL AT BE BG CH CY CZ DE DK EE ES FI GB GR HR HU IE IS IT LI LT LU LV MC MK MT NL NO PL PT RO RS SE SI SK SM TR**
- **Institut Polytechnique de Grenoble**
  **38500 Grenoble (FR)**
  Etats contractants désignés:
  **FR**

(72) Inventeurs:
- **BAICRY, Mathieu**
  **F-38360 Sassenage (FR)**
- **LE PRADO, Matthieu**
  **F-38160 Saint-Marcellin (FR)**
- **LEFROU, Christine**
  **F-38000 Grenoble (FR)**
- **ROUVE, Laure-Line**
  **F-38570 Theys (FR)**

(74) Mandataire: **Thibon, Laurent**
**Cabinet Beaumont**
**1, rue Champollion**
**38000 Grenoble (FR)**

(56) Documents cités:
**WO-A2-2007/078804**     **CA-A1- 2 272 429**
**FR-A1- 2 575 296**     **US-A- 4 349 781**

EP 3 066 484 B1

**Description**

Domaine

La présente demande concerne un procédé et un dispositif pour la mesure d'un champ électrique en milieu conducteur. Elle s'applique en particulier à des mesures de champ électrique sous-marines.

Exposé de l'art antérieur

On a déjà proposé un dispositif de mesure d'un champ électrique en mer, ou électromètre marin, comportant deux électrodes immergées éloignées d'une distance 1, reliées à un dispositif de mesure de tension. Pour mesurer un champ électrique E dans la zone située entre les deux électrodes, on mesure la tension U entre les électrodes. Le champ E se déduit de cette mesure par la formule E = U/l. Les électromètres de ce type sont dits "à mesure de tension".

Un inconvénient des électromètres à mesure de tension est que seule une très faible partie du courant se propageant dans le milieu conducteur constitué par l'eau de mer est déviée dans le dispositif de mesure de tension, ce qui pose des problèmes de métrologie. De plus, les électromètres à mesure de tension sont généralement encombrants. En effet, pour obtenir un rapport signal sur bruit satisfaisant, la distance 1 séparant les deux électrodes doit être relativement importante, typiquement de l'ordre de quelques mètres à plusieurs kilomètres.

Pour pallier ces inconvénients, on a proposé un autre type de dispositif de mesure de champ électrique en milieu conducteur, dit "à mesure de courant", qui réalise une détermination de la densité de courant produit, sous l'effet du champ électrique, dans un volume fixé de milieu conducteur.

Un dispositif de ce type est par exemple décrit dans le mémoire de thèse de doctorat intitulé "Appareillage de mesures des très faibles champs électriques en milieu marin : application à la mise en évidence des signaux électromagnétiques induits dans la mer" de Urbain Rakotosoa (Université Paris 6).

Les dispositifs de ce type, que l'on appellera ci-après électromètres à mesure de courant, peuvent être plus compacts que les électromètres à mesure de tension, et peuvent en outre présenter une meilleure sensibilité.

En outre, FR 2 575 296 décrit un dispositif de mesure d'un champ électrique dans un fluide conducteur.

La présente demande concerne plus particulièrement le domaine des électromètres à mesure de courant. Il serait en effet souhaitable d'améliorer certains aspects des électromètres à mesure de courant existants.

Résumé

Ainsi, un mode de réalisation prévoit un dispositif de mesure d'un champ électrique en milieu conducteur, comprenant : deux électrodes séparées par un volume d'un milieu isolant ; un dispositif de mesure de courant couplé aux électrodes ; et des éléments de réglage permettant de faire varier une grandeur dont dépend la conductivité électrique du dispositif de mesure de champ, la grandeur étant comprise dans le groupe comprenant l'impédance entre les deux électrodes du dispositif de mesure de champ, la distance entre les deux électrodes, et une surface active d'au moins une des électrodes.

Selon un mode de réalisation, la grandeur réglable est l'impédance entre les deux électrodes du dispositif de mesure de champ.

Selon un mode de réalisation, les éléments de réglage comportent une résistance variable couplée aux électrodes.

Selon un mode de réalisation, la grandeur réglable est la distance entre les deux électrodes.

Selon un mode de réalisation, les moyens de réglage comportent au moins un bras réglable en longueur couplé aux électrodes.

Selon un mode de réalisation, la grandeur réglable est une surface active d'au moins une des électrodes.

Selon un mode de réalisation, au moins une des électrodes comprend plusieurs panneaux conducteurs pouvant être interconnectés via des interrupteurs.

Selon un mode de réalisation de la présente invention, les moyens de réglage comportent un élément isolant susceptible de coulisser en translation devant au moins une des électrodes, entrainant une variation de la surface d'électrode en contact avec le milieu conducteur.

Selon un mode de réalisation, le dispositif comporte en outre des éléments de contrôle et de traitement adaptés à : a) mesurer le courant circulant entre les deux électrodes pour au moins deux valeurs distinctes de la grandeur réglable ; et b) déduire de ces mesures l'amplitude du champ électrique du milieu conducteur, et au moins une grandeur parmi l'impédance des électrodes et la conductivité du milieu conducteur.

Selon un mode de réalisation, les éléments de contrôle et de traitement sont adaptés, à l'étape a), à mesurer le courant circulant entre les deux électrodes pour au moins trois valeurs distinctes de la grandeur réglable, et, à l'étape b), à déduire des mesures l'amplitude du champ électrique du milieu conducteur, l'impédance des électrodes, et la conductivité du milieu conducteur.

Selon un mode de réalisation, l'étape b) comprend la résolution d'un système d'équations du type :

$$\frac{I}{E} = f\left(\frac{L}{S_A * \left(Z_{elec} + Z_{int}\right) * \sigma_e}\right),$$

où I désigne le courant mesuré entre les électrodes, L désigne la distance entre les électrodes, $S_A$ désigne la surface active des électrodes, $Z_{elec}$ désigne l'impédance des électrodes, $Z_{int}$ désigne l'impédance entre les électrodes, $\sigma_e$ désigne la conductivité du milieu conducteur, et f désigne une fonction analytique représentative de l'évolution du coefficient de conversion I/E en fonction du rapport $\sigma_c/\sigma_e$, avec $\sigma_c = L/(S_A*(Z_{elec} + Z_{int}))$.

Un autre mode de réalisation prévoit un procédé de calibration d'un dispositif de mesure de champ du type susmentionné, comportant les étapes suivantes : a) mesurer le courant circulant entre les deux électrodes pour au moins deux valeurs distinctes de la grandeur réglable ; et b) déduire de ces mesures l'amplitude du champ électrique du milieu conducteur, et au moins une grandeur parmi l'impédance des électrodes et la conductivité du milieu conducteur.

Selon un mode de réalisation, à l'étape a), on mesure le courant circulant entre les deux électrodes pour au moins trois valeurs distinctes de ladite grandeur, et, à l'étape b), on déduit des mesures l'amplitude du champ électrique dans le milieu conducteur, l'impédance des électrodes, et la conductivité du milieu conducteur.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 illustre de façon schématique un exemple d'électromètre à mesure de courant ;
la figure 2 est un diagramme illustrant un aspect du comportement d'un électromètre à mesure de courant ;
la figure 3 est un schéma illustrant sous forme de blocs un mode de réalisation d'un procédé de calibration d'un électromètre à mesure de courant ;
la figure 4 illustre de façon schématique un mode de réalisation d'un électromètre à mesure de courant ;
la figure 5 illustre de façon schématique une variante de réalisation d'un électromètre à mesure de courant ; et
la figure 6 illustre de façon schématique et partielle une autre variante de réalisation d'un électromètre à mesure de courant.

Description détaillée

Par souci de clarté, de mêmes éléments ont été désignés par de mêmes références aux différentes figures et, de plus, les diverses figures ne sont pas tracées à l'échelle. Par ailleurs, dans la suite de la description, sauf indication contraire, les termes "approximativement", "sensiblement", "environ", et "de l'ordre de", signifient "à 10 % près".

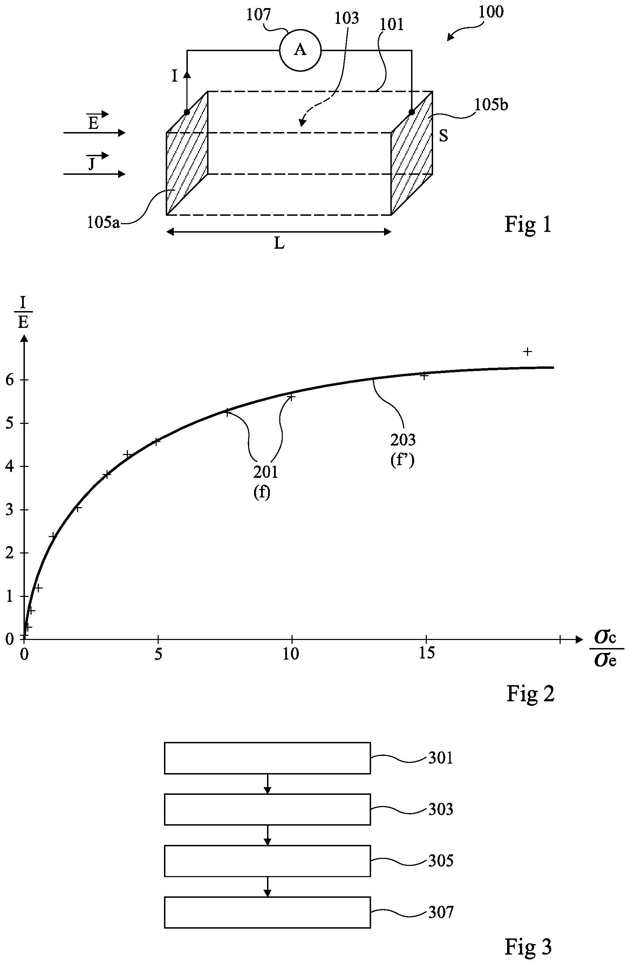

La figure 1 illustre de façon schématique un exemple d'un électromètre à mesure de courant 100 destiné à être placé dans un milieu conducteur dans lequel on souhaite mesurer un champ électrique, par exemple de l'eau de mer. Le dispositif 100 comprend une enceinte 101 hermétiquement close, représentée en traits pointillés sur la figure, délimitant un volume 103 d'un milieu isolant, par exemple de l'air ou du vide. Deux électrodes 105a et 105b sont disposées à l'extérieur de l'enceinte 101, de façon que chaque électrode ait une face en contact avec le milieu conducteur lorsque l'électromètre est immergé. Dans cet exemple, les deux électrodes 105a et 105b sont approximativement planes et parallèles entre elles, ont sensiblement la même surface S, et sont séparées par une distance L. Un dispositif de mesure de courant 107 relie les deux électrodes.

En fonctionnement, l'électromètre 100 est immergé dans un milieu conducteur soumis à un champ électrique E que l'on souhaite mesurer. Sous l'effet du champ électrique E, un courant de densité $J = \sigma_e*E$ circule dans le milieu conducteur, $\sigma_e$ désignant la conductivité électrique du milieu conducteur.

Les électrodes 105a et 105b permettent de canaliser la densité de courant J produite dans le milieu conducteur sous l'effet du champ E. Le courant canalisé I circulant entre les électrodes 105a et 105b est égal à I = S*J. Ce courant I peut être mesuré par le dispositif de mesure de courant 107.

La conductivité $\sigma_e$ du milieu conducteur dans lequel est utilisé l'électromètre 100 est supposée connue, et l'électromètre 100 est tel que son impédance est égale à celle de la tranche du milieu conducteur à laquelle est substitué l'électromètre. Le courant I mesuré par le dispositif 107 est alors proportionnel au champ électrique E, et le champ E peut se déduire de la mesure du courant I par la formule $E = I/(S*\sigma_e)$. L'électromètre peut comporter des moyens de traitement, non représentés, adaptés à déterminer le champ électrique E à partir de la mesure du courant I.

Un inconvénient de l'électromètre 100 est que, en pratique, la conductivité $\sigma_e$ du milieu conducteur peut être inconnue et/ou peut varier entre deux mesures, par exemple lorsque la concentration en sel de l'eau de mer varie lorsque l'électromètre est utilisé en milieu marin. De plus, avec le temps, les électrodes 105a et 105b peuvent s'altérer, ce qui peut entrainer une modification de leur impédance et donc une modification de l'impédance de l'électromètre. En pratique, il peut donc exister un écart entre l'impédance de l'électromètre et l'impédance de la tranche du milieu conducteur à laquelle est substitué l'électromètre. Dans ces conditions, le coefficient de proportionnalité utilisé par l'électromètre pour déterminer le champ électrique E à partir de la mesure du courant I n'est plus valable, ce qui entraine des erreurs de mesure.

Il serait souhaitable de pouvoir disposer d'un électromètre à mesure de courant pouvant être calibré facilement dans son environnement d'utilisation, pour pouvoir fournir des mesures précises de champ électrique y compris en cas de variation de la conductivité électrique du milieu conducteur à l'étude, ou de l'impédance des électrodes de l'électromètre.

Selon un aspect, on prévoit ici un électromètre à mesure de courant comportant des moyens ou éléments de réglage permettant de faire varier une grandeur dont dépend la conductivité électrique de l'électromètre.

Par conductivité électrique de l'électromètre, on entend ici la grandeur $\sigma_c = L/(S_A * Z_C)$, où $S_A$ désigne une surface d'électrode active pour la canalisation de la densité de courant J circulant dans le milieu conducteur, et où $Z_C$ désigne l'impédance de l'électromètre, avec $Z_c = Z_{elec} + Z_{int}$, $Z_{elec}$ étant l'impédance des électrodes de l'électromètre et $Z_{int}$ étant l'impédance du ou des éléments connectés entre les électrodes, parmi lesquels on trouve au moins le dispositif de mesure de courant 107.

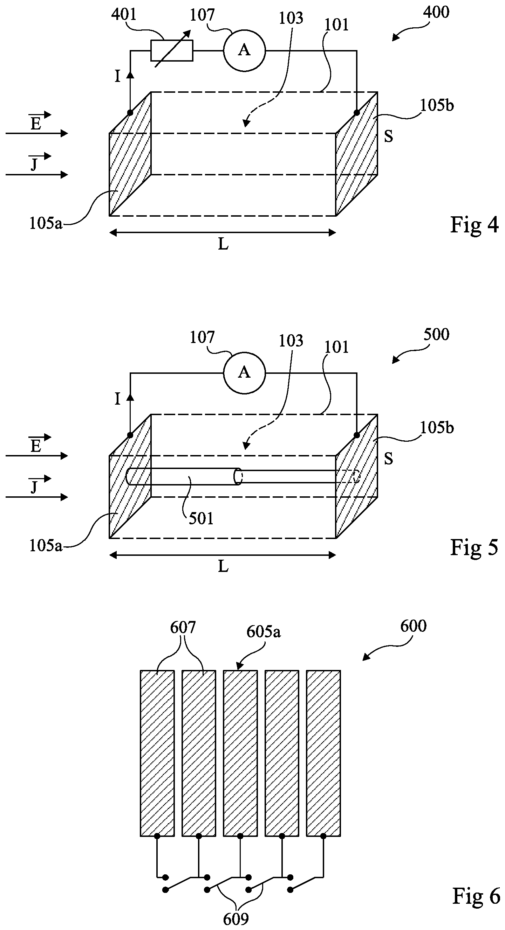

La grandeur réglable peut être l'impédance $Z_{int}$ des éléments connectés entre les électrodes, comme cela sera expliqué plus en détail en relation avec la figure 4, la distance L entre les électrodes, comme cela sera expliqué plus en détail en relation avec la figure 5, ou la surface $S_A$ d'électrode active pour la canalisation de la densité de courant J circulant dans le milieu conducteur, comme cela sera expliqué plus en détail en relation avec la figure 6. Les moyens de réglages sont prévus pour permettre de régler à une valeur connue la grandeur réglable.

Les études menées par les inventeurs ont montré que, pour un électromètre à mesure de courant donné, dans les conditions habituelles d'utilisation de l'électromètre, le courant I mesuré par le dispositif de mesure de courant 107 de l'électromètre est toujours proportionnel au champ électrique E dans le milieu conducteur, et que le rapport de proportionnalité I/E varie en fonction du rapport $\sigma_c/\sigma_e$ entre la conductivité de l'électromètre et la conductivité du milieu conducteur dans lequel se trouve l'électromètre, selon une fonction f telle que : $I/E = f(\sigma_c/\sigma_e)$.

Pour un électromètre donné, la fonction f peut être déterminée par calcul (simulation) ou expérimentalement. A titre d'exemple, pour déterminer expérimentalement la fonction f, on peut placer l'électromètre dans un environnement contrôlé, par exemple dans une piscine de test en laboratoire, dans un milieu conducteur de conductivité $\sigma_e$ connue, et sous un champ électrique E connu. On peut alors réaliser une série de mesures successives du courant I canalisé par l'électromètre, en modifiant, entre chaque mesure, la valeur du rapport de conductivités $\sigma_c/\sigma_e$. Pour cela, on peut par exemple modifier, entre chaque mesure, la valeur de la grandeur réglable de l'électromètre dont dépend la conductivité électrique de l'électromètre. A titre de variante, si l'équipement d'expérimentation le permet, on peut se placer à conductivité $\sigma_c$ de l'électromètre constante, et faire varier, entre chaque mesure, la valeur de la conductivité $\sigma_e$ du milieu conducteur. La valeur du champ électrique E étant connue, on peut en déduire, pour une pluralité de valeurs connues du rapport $\sigma_c/\sigma_e$, la valeur correspondante $f(\sigma_c/\sigma_e)$. A partir des points expérimentaux de la courbe $I/E = f(\sigma_c/\sigma_e)$, on peut déterminer, par une méthode d'ajustement de courbe ("curve fitting" en anglais), une fonction mathématique f' approximant la fonction f et pouvant être assimilée à la fonction f.

La figure 2 est un diagramme illustrant la forme de la fonction f pour un électromètre comportant une enceinte isolante en forme de cylindre droit de 40 centimètres de rayon, dont les électrodes sont disposées sur les deux faces circulaires opposées de l'enceinte, et sont séparées par une distance L de 1 mètre.

Sur la figure 2, l'axe des abscisses (horizontal dans l'orientation de la figure 2) représente le rapport $\sigma_c/\sigma_e$, et l'axe des ordonnées (vertical dans l'orientation de la figure 2) représente le rapport de proportionnalité I/E, en nA/(nV/m). Les croix 201 de la figure 2 représentent les points de la fonction f déterminés expérimentalement, et la courbe 203 en trait plein représente la fonction f' approximant la fonction f, déterminée par une méthode d'ajustement de courbe. Dans la suite, les fonctions f et f' sont considérées identiques.

Les essais menés par les inventeurs ont montré que pour tout électromètre comportant une enceinte isolante en forme de cylindre droit de rayon R, dont les électrodes sont disposées sur les deux faces circulaires opposées de l'enceinte, et sont séparées par une distance L, la fonction mathématique f déterminée par la méthode susmentionnée peut s'exprimer par la formule suivante :

$$\frac{I}{E} = f\left(\frac{\sigma_c}{\sigma_e}\right) = S\sigma_e\alpha \, ,$$

où S est la surface des électrodes et où $\alpha$ est le terme suivant :

$$\alpha = \frac{\sigma_c}{\sigma_e} + \frac{1 - \dfrac{\sigma_c}{\sigma_e}}{1 + 1,45\dfrac{\sigma_c}{\sigma_e}\left(\dfrac{L}{R}\right)^{0,92}} \, .$$

Plus généralement, pour toutes les formes usuelles d'électromètre, une expression mathématique ou expression analytique de la fonction f peut être déterminée par la méthode susmentionnée.

En pratique, la fonction f peut être déterminée une seule fois, par exemple juste après la fabrication de l'électromètre. La méthode d'ajustement de courbe susmentionnée peut être mise en oeuvre au moyen d'une unité de traitement qui peut être interne ou externe à l'électromètre. L'électromètre peut être équipé d'une unité de traitement adaptée à calculer des valeurs de la fonction f lors de phases ultérieures de calibration in-situ de l'électromètre, comme cela sera expliqué plus en détail en relation avec la figure 3.

La figure 3 représente schématiquement, sous forme de blocs, un exemple d'un mode de réalisation d'un procédé de calibration d'un électromètre à mesure de courant comportant des moyens de réglage permettant de faire varier une grandeur dont dépend la conductivité électrique de l'électromètre. Dans cet exemple, la grandeur réglable est l'impédance $Z_{int}$ des éléments connectés entre les électrodes de l'électromètre. La fonction f de transfert entre le rapport de conductivité $\sigma_c/\sigma_e$ et le rapport de proportionnalité I/E est supposée connue, et l'électromètre comporte une unité de traitement adaptée à calculer des valeurs de la fonction f.

Lors d'une étape 301, l'impédance des éléments connectés entre les électrodes de l'électromètre est fixée à une valeur connue $Z_{int1}$, puis une valeur I1 du courant canalisé par l'électromètre est mesurée.

Lors d'une étape 303 postérieure à l'étape 301, l'impédance des éléments connectés entre les électrodes de l'électromètre est fixée à une valeur connue $Z_{int2}$ différente de $Z_{int1}$, puis une valeur I2 du courant canalisé par l'électromètre est mesurée.

Lors d'une étape 305 postérieure à l'étape 303, l'impédance des éléments connectés entre les électrodes de l'électromètre est fixée à une valeur connue $Z_{int3}$ différente de $Z_{int1}$ et de $Z_{int2}$, puis une valeur I3 du courant canalisé par l'électromètre est mesurée.

A l'issue de ces trois étapes de mesure, on dispose d'un système à trois équations et trois inconnues qui s'exprime comme suit :

$$\frac{I1}{E} = f\left(\frac{L}{S_A * (Z_{elec} + Z_{int1}) * \sigma_e}\right)$$

$$\frac{I2}{E} = f\left(\frac{L}{S_A * (Z_{elec} + Z_{int2}) * \sigma_e}\right)$$

$$\frac{I3}{E} = f\left(\frac{L}{S_A * (Z_{elec} + Z_{int3}) * \sigma_e}\right)$$

Les valeurs I1, I2, I3, L, $S_A$, $Z_{int1}$, $Z_{int2}$ et $Z_{int3}$ sont des valeurs connues, et les valeurs E, $Z_{elec}$ et $\sigma_e$ sont les inconnues du système.

Lors d'une étape 307 postérieure à l'étape 305, le système d'équations susmentionné est résolu par toute méthode appropriée de résolution d'un système à trois équations et trois inconnues. On détermine ainsi la valeur du champ E, la valeur de l'impédance $Z_{elec}$ des électrodes, et la valeur de la conductivité électrique $\sigma_e$ du milieu conducteur à l'étude. La résolution du système d'équations peut être mise en oeuvre par une unité de traitement de l'électromètre. Une fois les valeurs du champ E, de l'impédance $Z_{elec}$, et de la conductivité $\sigma_e$ déterminées,

l'impédance $Z_{int}$ des éléments connectés entre les électrodes de l'électromètre peut être fixée à une valeur connue quelconque, et le rapport de proportionnalité I/E peut être déterminé à l'aide de la fonction f. A titre d'exemple, l'impédance $Z_{int}$ peut être fixée à une valeur telle que l'impédance $Z_c = Z_{int} + Z_{elec}$ de l'électromètre soit approximativement égale à l'impédance de la tranche du milieu conducteur à laquelle se substitue l'électromètre. Les modes de réalisation décrits ne se limitent toutefois pas à ce cas particulier.

La calibration de l'électromètre est alors terminée, et des mesures de champ électrique peuvent être réalisées sur la base du coefficient de proportionnalité I/E déterminé à l'étape 307.

Le procédé de calibration de la figure 3 peut être répété aussi souvent que nécessaire, pour éviter que la dérive éventuelle des paramètres d'impédance $Z_{elec}$ et de conductivité $\sigma_e$ n'entraine une dégradation significative de la précision de l'électromètre.

Il apparaîtra au lecteur que le procédé de calibration de la figure 3 fonctionne de façon similaire ou identique à ce qui vient d'être décrit dans le cas où la grandeur réglable de l'électromètre est la distance L entre les électrodes, ou la surface $S_A$ d'électrode active pour la canalisation de la densité de courant J. Dans ce cas, au lieu de faire varier l'impédance $Z_{int}$ des éléments connectés entre les électrodes lors des différentes étapes de mesure 301, 303 et 305 du procédé de calibration, on fait varier respectivement la distance L entre les électrodes, ou la surface $S_A$ d'électrode active. On obtient alors, comme précédemment, un système à trois équations et trois inconnues qui peut être résolu pour déterminer les valeurs du champ E, de l'impédance $Z_{elec}$, et de la conductivité $\sigma_e$ du milieu conducteur (étape 307).

La figure 4 illustre de façon schématique un exemple d'un mode de réalisation d'un électromètre à mesure de courant 400 adapté à la mise en oeuvre d'un procédé de calibration du type décrit en relation avec la figure 3, dans lequel la grandeur réglable utilisée pour la calibration est l'impédance $Z_{int}$ des éléments connectés entre les électrodes.

Comme l'électromètre 100 de la figure 1, l'électromètre 400 de la figure 4 comprend une enceinte 101 hermétiquement close, représentée en traits pointillés sur la figure, délimitant un volume 103 d'un milieu isolant, par exemple de l'air ou du vide. L'électromètre 400 comprend en outre deux électrodes 105a et 105b disposées à l'extérieur de l'enceinte 101, de façon que chaque électrode ait une face en contact avec le milieu conducteur lorsque l'électromètre est immergé. Dans cet exemple, les électrodes 105a et 105b sont approximativement planes et parallèles entre elles, et recouvrent respectivement deux faces extérieures opposées de l'enceinte 101. A titre de variante, les électrodes 105a et 105b peuvent constituer elles-mêmes des parois de l'enceinte 101. Dans l'exemple représenté, l'enceinte 101 est approximativement parallélépipédique, et les électrodes 105a et 105b recouvrent deux faces rectangulaires de même surface S de l'enceinte 101. Les modes de réalisation décrits ne se limitent toutefois pas à cette forme particulière d'électromètre. A titre de variante, l'enceinte 101 peut avoir une forme cylindrique ou toute autre forme appropriée, et les électrodes 105a et 105b peuvent avoir une forme circulaire ou toute autre forme appropriée, plane ou non plane. Dans cet exemple, les électrodes 105a et 105b sont séparées par une distance L qui correspond approximativement à la longueur de l'enceinte 101.

Comme dans l'exemple de la figure 1, l'électromètre 400 comprend un dispositif de mesure de courant 107 reliant les deux électrodes. Le dispositif 107 est par exemple disposé à l'intérieur de l'enceinte 101. Le dispositif 107 est par exemple un ampèremètre. A titre de variante, le dispositif 107 peut être un circuit de mesure de courant à transformateur et amplificateur du type décrit dans le mémoire de thèse susmentionné intitulé "Appareillage de mesures des très faibles champs électriques en milieu marin : application à la mise en évidence des signaux électromagnétiques induits dans la mer" de Urbain Rakotosoa (Université Paris 6), notamment aux pages 10 à 13 du mémoire, en relation avec la figure I.1 du mémoire. A titre de variante, le dispositif 107 peut être un système à bobines à un ou plusieurs magnétomètres, du type décrit dans le brevet US5440226, notamment en relation avec les figures 1 et 2 de ce brevet.

L'électromètre 400 comprend des moyens ou éléments de réglage de l'impédance des éléments connectés entre les électrodes 105a et 105b. Dans l'exemple représenté, ces moyens de réglage sont constitués par une résistance variable 401 couplée entre les électrodes 105a et 105b, par exemple connectée en série avec le dispositif 107 entre les électrodes 105a et 105b.

L'électromètre 400 peut en outre comprendre des moyens ou éléments de contrôle et de traitement, non représentés, adaptés notamment à mettre en oeuvre le procédé de calibration susmentionné et à effectuer des mesures de champ électrique lorsque l'électromètre est calibré. Ces moyens de contrôle et de traitement sont notamment adaptés à commander la résistance variable 401.

La figure 5 illustre de façon schématique un exemple d'un mode de réalisation d'un électromètre à mesure de courant 500 adapté à la mise en oeuvre d'un procédé de calibration du type décrit en relation avec la figure 3, dans lequel la grandeur réglable utilisée lors de la calibration est la distance L entre les électrodes. L'électromètre 500 de la figure 5 comprend de nombreux éléments communs avec l'électromètre 400 de la figure 4. Seules les différences entre ces deux électromètres seront exposées ci-après.

L'électromètre 500 de la figure 5 diffère de l'électromètre 400 de la figure 4 en ce que, dans l'électromètre 500, la distance L entre les électrodes 105a et 105b n'est pas fixe, mais peut être réglée via des moyens ou éléments de réglage comprenant, dans cet exemple, au moins un bras 501 de longueur réglable reliant les deux électrodes 105a et 105b. Dans l'exemple représenté, le bras 501 est un bras télescopique dont une première extrémité est fixée à l'électrode 105a sensiblement en son centre, et dont une deuxième extrémité est fixée à l'électrode 105b sensiblement en son centre. La longueur du bras 501 peut être réglée au moyen d'un moteur non représenté. Plus généralement, tout autre moyen de réglage permettant de faire varier la distance L séparant les électrodes 105a et 105b peut être prévu. Les parois de l'enceinte 101 sont par exemple en un matériau extensible, ce qui permet la mobilité des électrodes 105a et 105b tout en préservant l'étanchéité de l'enceinte 101. A titre de variante, l'enceinte 101 peut être rigide et au moins une des parois supportant les électrodes 105a et 105b peut coulisser en translation dans le volume délimité par les autres parois de l'enceinte 101. Des moyens d'étanchéité peuvent être prévus pour éviter que de l'eau de mer ne pénètre à l'intérieur de l'enceinte 101 aux interfaces entre la paroi mobile et les parois fixes de l'enceinte.

L'électromètre 500 peut comprendre des moyens ou éléments de contrôle et de traitement, non représentés, adaptés notamment à mettre en oeuvre le procédé de calibration susmentionné et à effectuer des mesures de champ électrique lorsque l'électromètre est calibré. Ces moyens de contrôle et de traitement sont notamment adaptés à commander le réglage en longueur du bras 501 dans cet exemple.

L'électromètre 500 peut en outre optionnellement comporter une résistance variable (non représentée en figure 5) couplée entre les électrodes 105a et 105b, par exemple en série avec le dispositif de mesure de courant 107 comme dans l'exemple de la figure 4, permettant de régler à une valeur connue l'impédance $Z_{int}$ des éléments de l'électromètre connectés entre les électrodes 105a et 105b. Dans ce cas, lors de l'étape 307 du procédé de calibration (figure 3), une fois les valeurs du champ E, de l'impédance $Z_{elec}$, et de la conductivité $\sigma_e$ déterminées, l'impédance $Z_{int}$ des éléments connectés entre les électrodes de l'électromètre peut être fixée à une valeur telle que l'impédance $Z_c = Z_{int} + Z_{elec}$ de l'électromètre soit approximativement égale à l'impédance de la tranche du milieu conducteur à laquelle se substitue l'électromètre. Les modes de réalisation décrits ne se limitent toutefois pas à ce cas particulier.

La figure 6 illustre de façon schématique et partielle un exemple d'un mode de réalisation d'un électromètre à mesure de courant 600 adapté à la mise en oeuvre d'un procédé de calibration du type décrit en relation avec la figure 3, dans lequel la grandeur réglable utilisée lors de la calibration est la surface $S_A$ d'électrode active pour la canalisation de la densité de courant J dans le milieu conducteur.

L'électromètre de la figure 6 diffère de l'électromètre de la figure 4 principalement par la structure de ses électrodes. En figure 6, on a représenté, vue de face, une électrode 605a de l'électromètre, disposée sur une face de l'enceinte 101 (non visible sur la figure 6), en remplacement de l'électrode 105a de l'électromètre de la figure 4. L'électromètre de la figure 6 peut en outre comporter une autre électrode (non représentée) identique ou similaire à l'électrode 605a, disposée sur une face de l'enceinte 101 opposée à l'électrode 605a, en remplacement de l'électrode 105b de l'électromètre de la figure 4.

L'électrode 605a comprend, dans cet exemple, une pluralité de panneaux métalliques 607 disjoints. L'électromètre de la figure 6 comprend en outre des moyens ou éléments de réglage comportant une pluralité d'interrupteurs 609 permettant d'interconnecter tout ou partie des panneaux conducteurs 607. En choisissant, par l'intermédiaire des interrupteurs 609, le nombre de panneaux conducteurs 607 que l'on connecte au dispositif de mesure de courant 107 (non visible sur la figure 6) de l'électromètre, on peut régler la surface $S_A$ d'électrode active pour la canalisation de la densité de courant J dans le milieu conducteur.

L'électromètre de la figure 6 peut comprendre des moyens ou éléments de contrôle et de traitement, non représentés, adaptés notamment à mettre en oeuvre le procédé de calibration susmentionné et à effectuer des mesures de champ électrique lorsque l'électromètre est calibré. Ces moyens de contrôle et de traitement sont notamment adaptés à commander les interrupteurs 609 dans cet exemple.

L'électromètre de la figure 6 peut en outre optionnellement comporter une résistance variable (non représentée en figure 6) couplée entre ses électrodes, par exemple en série avec le dispositif de mesure de courant 107 comme dans l'exemple de la figure 4, permettant de régler à une valeur connue l'impédance $Z_{int}$ des éléments de l'électromètre connectés entre ses électrodes. Dans ce cas, lors de l'étape 307 du procédé de calibration (figure 3), une fois les valeurs du champ E, de l'impédance $Z_{elec}$, et de la conductivité $\sigma_e$ déterminées, l'impédance $Z_{int}$ des éléments connectés entre les électrodes de l'électromètre peut être fixée à une valeur telle que l'impédance $Z_c = Z_{int} + Z_{elec}$ de l'électromètre soit approximativement égale à l'impédance de la tranche du milieu conducteur à laquelle se substitue l'électromètre. Les modes de réalisation décrits ne se limitent toutefois pas à ce cas particulier.

A titre de variante, pour faire varier la surface $S_A$ d'électrode active pour la canalisation de la densité de courant J dans le milieu conducteur, on peut prévoir de masquer une partie de la surface d'une électrode au moyen d'un élément isolant tel qu'un film isolant, une feuille isolante, ou une plaque isolante, de façon à faire varier la surface d'électrode en contact avec le milieu conducteur. Des moyens d'entraînement motorisés de l'élément isolant peuvent être prévus pour provoquer des variations de la surface active $S_A$.

Un avantage des modes de réalisation décrits ci-dessus est que l'électromètre peut facilement être calibré in-situ, ce qui permet d'obtenir des mesures précises de champ électrique, même lorsque les valeurs $Z_{elec}$ d'impédance des électrodes et $\sigma_e$ de conductivité du milieu conducteur dans lequel est utilisé l'électromètre sont susceptibles de dériver.

Des modes de réalisation particuliers ont été décrits. Diverses variantes et modifications apparaîtront à l'homme de l'art.

En particulier, on a décrit ci-dessus un procédé de calibration dans lequel on effectue successivement trois mesures du courant I canalisé par les électrodes de l'électromètre, en modifiant à chaque mesure une grandeur réglable de l'électromètre dont dépend la conductivité de l'électromètre. Ceci permet, par la résolution d'un système à trois équations et trois inconnues, de déterminer à la fois le champ E dans le milieu conducteur, l'impédance $Z_{elec}$ des électrodes de l'électromètre, et la conductivité $\sigma_e$ du milieu conducteur. On peut toutefois envisager le cas où l'impédance $Z_{elec}$ des électrodes est connue et stable et où seule la conductivité $\sigma_e$ du milieu conducteur est inconnue, ou, à l'inverse, le cas où la conductivité $\sigma_e$ est connue et stable, et où seule l'impédance $Z_{elec}$ des électrodes est inconnue. Dans ces deux cas, on peut prévoir un procédé de calibration comprenant seulement deux étapes de mesure du courant I avec des valeurs distinctes de la grandeur réglable de l'électromètre, et la résolution d'un système à deux équations et deux inconnues.

Par ailleurs, on notera que les variantes de réalisation des figures 4, 5 et 6 peuvent être combinées entre elles, c'est-à-dire qu'on peut prévoir un électromètre dans lequel à la fois l'impédance $Z_{int}$, la surface active $S_A$ et la distance inter-électrodes L sont réglables, ou dans lequel deux quelconques de ces paramètres sont réglables. Lors de la calibration, on peut alors prévoir, entre deux mesures successives du courant I, de faire varier des paramètres réglables distincts, ou une combinaison appropriée des paramètres réglables, pour obtenir le nombre d'équations souhaité.

En outre, les modes de réalisation décrits ne se limitent pas à des applications en milieux marins mais peuvent être utilisés dans d'autres milieux conducteurs.

## Revendications

1. Dispositif (400 ; 500 ; 600) de mesure d'un champ électrique en milieu conducteur, comprenant :

deux électrodes (105a, 105b ; 605a) séparées par un volume (103) d'un milieu isolant ;
un dispositif (107) de mesure de courant couplé auxdites électrodes (105a, 105b ; 605a) ; et **caractérisé par** des éléments de réglage permettant de faire varier une grandeur dont dépend la conductivité électrique ($\sigma_c$) du dispositif de mesure de champ électrique, ladite grandeur étant comprise dans le groupe comprenant l'impédance ($Z_{int}$) entre les deux électrodes (105a, 105b) du dispositif de mesure de champ électrique, la distance (L) entre les deux électrodes (105a, 105b), et une surface active ($S_A$) d'au moins une desdites électrodes (605a).

2. Dispositif (400) selon la revendication 1, dans lequel ladite grandeur est l'impédance entre les deux électrodes (105a, 105b) du dispositif de mesure de champ électrique.

3. Dispositif (400) selon la revendication 2, dans lequel lesdits éléments de réglage comportent une résistance variable (401) couplée auxdites électrodes (105a, 105b).

4. Dispositif (500) selon l'une quelconque des revendications 1 à 3, dans lequel ladite grandeur est la distance (L) entre les deux électrodes (105a, 105b).

5. Dispositif (500) selon la revendication 4, dans lequel lesdits moyens de réglage comportent au moins un bras (501) réglable en longueur couplé auxdites électrodes (105a, 105b).

6. Dispositif (600) selon l'une quelconque des revendications 1 à 5, dans lequel ladite grandeur est une surface active d'au moins une desdites électrodes (605a).

7. Dispositif (600) selon la revendication 6, dans lequel au moins une desdites électrodes (605a) comprend plusieurs panneaux conducteurs (607) pouvant être interconnectés via des interrupteurs (609).

8. Dispositif selon la revendication 6, dans lequel lesdits moyens de réglage comportent un élément isolant susceptible de coulisser en translation devant au moins une desdites électrodes, entrainant une variation de la surface d'électrode en contact avec le milieu conducteur.

9. Dispositif (400 ; 500 ; 600) selon l'une quelconque des revendications 1 à 8, comportant en outre des éléments de contrôle et de traitement adaptés à :

a) mesurer le courant (I) circulant entre les deux électrodes (105a, 105b ; 605a) pour au moins deux valeurs distinctes de ladite grandeur ; et
b) déduire desdites mesures l'amplitude du champ électrique (E) du milieu conducteur, et au moins une grandeur parmi l'impédance desdites électrodes et la conductivité du milieu conducteur.

10. Dispositif (400 ; 500 ; 600) selon la revendication 9, dans lequel lesdits éléments de contrôle et de traitement sont adaptés, à l'étape a), à mesurer le courant (I) circulant entre les deux électrodes pour au moins trois valeurs distinctes de ladite grandeur, et, à l'étape b), à déduire desdites mesures l'amplitude du champ électrique (E) du milieu conducteur, l'impédance desdites électrodes, et la conductivité ($\sigma_e$) du milieu conducteur.

11. Dispositif (400 ; 500 ; 600) selon la revendication 9 ou 10, dans lequel l'étape b) comprend la résolution d'un système d'équations du type :

$$\frac{I}{E} = f\left( \frac{L}{S_A * (Z_{elec} + Z_{int}) * \sigma_e} \right),$$

où I désigne le courant mesuré entre les électrodes, L désigne la distance entre les électrodes, $S_A$ désigne la surface active des électrodes, $Z_{elec}$ désigne l'impédance des électrodes, $Z_{int}$ désigne l'impédance entre les électrodes, $\sigma_e$ désigne la conductivité du milieu conducteur, et f désigne une fonction analytique représentative de l'évolution du coefficient de conversion I/E en fonction du rapport $\sigma_c/\sigma_e$, avec $\sigma_c = L/(S_A*(Z_{elec} + Z_{int})$.

12. Procédé de calibration d'un dispositif (400 ; 500 ; 600) de mesure de champ électrique selon l'une quelconque des revendications 1 à 11, comportant les étapes suivantes :

a) mesurer le courant (I) circulant entre les deux électrodes (105a, 105b ; 605a) pour au moins deux valeurs distinctes de ladite grandeur ; et
b) déduire desdites mesures l'amplitude du champ électrique (E) du milieu conducteur, et au moins une grandeur parmi l'impédance desdites électrodes et la conductivité ($\sigma_e$) du milieu conducteur.

13. Procédé selon la revendication 12, dans lequel, à l'étape a), on mesure le courant (I) circulant entre les deux électrodes (105a, 105b ; 605a) pour au moins trois valeurs distinctes de ladite grandeur, et, à l'étape b), on déduit desdites mesures l'amplitude du champ électrique (E) dans le milieu conducteur, l'impédance desdites électrodes, et la conductivité ($\sigma_e$) du milieu conducteur.

**Patentansprüche**

1. Vorrichtung (400; 500; 600) zum Messen eines elektrischen Felds in einem leitenden Medium, die Folgendes aufweist:

zwei Elektroden (105a, 105b; 605a), die durch ein Volumen (103) eines isolierenden Mediums getrennt sind;
eine Strommessvorrichtung (107), die mit den Elektroden (105a, 105b; 605a) gekoppelt ist; **da-**

**durch gekennzeichnet, dass**

Anpassungselemente, die die Anpassung einer Variable ermöglichen, von der die elektrische Leitfähigkeit ($\sigma_c$) der Messvorrichtung des elektrischen Felds abhängt, wobei die Variable in der Gruppe enthalten ist, die die Impedanz ($Z_{int}$) zwischen den zwei Elektroden (105a, 105b) der Messvorrichtung des elektrischen Felds, die Entfernung (L) zwischen den zwei Elektroden (105a, 105b) und eine aktive Oberfläche ($S_A$) der zumindest einen Elektrode (605a) aufweist.

2. Vorrichtung (400) gemäß Anspruch 1, wobei die Variable die Impedanz zwischen den zwei Elektroden (105a, 105b) der Messvorrichtung des elektrischen Felds ist.

3. Vorrichtung (400) gemäß Anspruch 2, wobei die Anpassungselemente einen variablen Widerstand (401) aufweisen, der mit den Elektroden (105a, 105b) gekoppelt ist.

4. Vorrichtung (500) gemäß einem der Ansprüche 1 bis 3, wobei die Variable die Entfernung (L) zwischen den zwei Elektroden (105a, 105b) ist.

5. Vorrichtung (500) gemäß Anspruch 4, wobei die Anpassungselemente zumindest einen Arm (501) anpassbarer Länge aufweisen, der mit den Elektroden (105a, 105b) gekoppelt ist.

6. Vorrichtung (600) gemäß einem der Ansprüche 1 bis 5, wobei die Variable ein aktiver Oberflächenbereich von zumindest einer der Elektroden (605a) ist.

7. Vorrichtung (600) gemäß Anspruch 6, wobei zumindest eine der Elektroden (605a) eine Vielzahl von leitenden Panels bzw. Feldern (607) aufweist, die imstande sind miteinander über Schalter (609) verbunden zu werden.

8. Vorrichtung gemäß Anspruch 6, wobei die Anpassungselemente ein Isolierelement aufweisen, das imstande ist, vor zumindest einer der Elektroden zu gleiten bzw. verschoben zu werden, wodurch eine Variation des Elektrodenoberflächenbereichs in Kontakt mit dem leitenden Medium verursacht wird.

9. Vorrichtung (400; 500; 600) gemäß einem der Ansprüche 1 bis 8, die ferner Steuerungs- und Verarbeitungselemente aufweist, die imstande sind Folgendes zu tun:

a) Messen des Stroms (I), der zwischen den zwei Elektroden (105a, 105b; 605a) fließt, und zwar für zumindest zwei unterschiedliche Werte der Variable; und
b) Rückschließen aus den Messungen der Amplitude des elektrischen Felds (E) des leitenden Mediums, auf zumindest eine Variable aus der Impedanz der Elektroden und der Leitfähigkeit des leitenden Mediums.

10. Vorrichtung (400; 500; 600) gemäß Anspruch 9, wobei die Steuerungs- und Verarbeitungselemente imstande sind, bei Schritt a) den Strom (I), der zwischen den zwei Elektroden fließt, für zumindest drei unterschiedliche Werte der Variable zu messen und bei Schritt b) aus den Messungen der Amplitude des elektrischen Felds (E) des leitenden Mediums auf die Impedanz der Elektroden und die Leitfähigkeit ($\sigma_e$) des leitenden Mediums rückzuschließen.

11. Vorrichtung (400; 500; 600) gemäß Anspruch 9 oder 10, wobei Schritt b) das Lösen eines Systems von Gleichungen der folgenden Art aufweist:

$$\frac{I}{E} = f\left(\frac{L}{S_A * (Z_{elec} + Z_{int}) * \sigma_e}\right),$$

wobei I den Strom bezeichnet, der zwischen den Elektroden gemessen wird, L die Entfernung zwischen den Elektroden bezeichnet, $S_A$ den aktiven Oberflächenbereich der Elektroden bezeichnet, $Z_{elec}$ die Impedanz der Elektroden bezeichnet, $Z_{int}$ die Impedanz zwischen den Elektroden bezeichnet, $\sigma_e$ die Leitfähigkeit des leitenden Mediums bezeichnet, und f eine analytische Funktion bezeichnet, die repräsentativ für die Variation des Umwandlungskoeffizienten I/E gemäß dem Verhältnis $\sigma_c/\sigma_e$ ist, wobei $\sigma_c = L/(S_A*(Z_{elec} + Z_{int})$ ist.

12. Verfahren zum Kalibrieren der Messvorrichtung (400; 500; 600) des elektrischen Felds gemäß einem der Ansprüche 1 bis 11, das die folgenden Schritte aufweist:

a) Messen des Stroms (I), der zwischen den zwei Elektroden (105a, 105b; 605a) fließt, und zwar für zumindest zwei unterschiedliche Werte der Variable; und
b) Rückschließen aus den Messungen der Amplitude des elektrischen Felds (E) des leitenden Mediums, auf zumindest eine Variable aus der Impedanz der Elektroden und der Leitfähigkeit ($\sigma_e$) des leitenden Mediums.

13. Verfahren gemäß Anspruch 12, wobei bei Schritt a), der Strom (I), der zwischen den zwei Elektroden (105a, 105b; 605a) fließt, für zumindest drei unterschiedliche Werte der Variable gemessen wird, und bei Schritt b) die Amplitude des elektrischen Felds (E) in dem leitenden Medium, die Impedanz der Elektroden, und die Leitfähigkeit ($\sigma_e$) des leitenden Me-

diums aus den Messungen rückgeschlossen werden.

## Claims

1. A device (400; 500; 600) for measuring an electric field in a conducting medium, comprising:

two electrodes (105a, 105b; 605a) separated by a volume (103) of an insulating medium; a current measurement device (107) coupled to said electrodes (105a, 105b; 605a); **characterized in that** adjustment elements enabling the adjustment of a variable having the electric conductivity ($\sigma_c$) of the electric field measurement device depending thereon, said variable being comprised in the group comprising the impedance ($Z_{int}$) between the two electrodes (105a, 105b) of the electric field measurement device, the distance (L) between the two electrodes (105a, 105b), and an active surface ($S_A$) of at least one of said electrodes (605a) .

2. The device (400) of claim 1, wherein said variable is the impedance between the two electrodes (105a, 105b) of the electric field measurement device.

3. The device (400) of claim 2, wherein said adjustment elements comprise a variable resistor (401) coupled to said electrodes (105a, 105b).

4. The device (500) of any of claims 1 to 3, wherein said variable is the distance (L) between the two electrodes (105a, 105b).

5. The device (500) of claim 4, wherein said adjustment elements comprise at least one arm (501) of adjustable length coupled to said electrodes (105a, 105b).

6. The device (600) of any of claims 1 to 5, wherein said variable is an active surface area of at least one of said electrodes (605a).

7. The device (600) of claim 6, wherein at least one of said electrodes (605a) comprises a plurality of conductive panels (607) capable of being interconnected via switches (609).

8. The device of claim 6, wherein said adjustment elements comprise an insulating element capable of sliding in front of at least one of said electrodes, causing a variation of the electrode surface area in contact with the conducting medium.

9. The device (400; 500; 600) of any of claims 1 to 8, further comprising control and processing elements capable of:

a) measuring the current (I) flowing between the two electrodes (105a, 105b; 605a) for at least two different values of said variable; and
b) deducing from the measurements the amplitude of the electric field (E) of the conducting medium, and at least one variable from among the impedance of said electrodes and the conductivity of the conducting medium.

10. The device (400; 500; 600) of claim 9, wherein said control and processing elements are capable, at step a), of measuring the current (I) flowing between the two electrodes for at least three different values of said variable and, at step b), deducing from said measurements the amplitude of the electric field (E) of the conducting medium, the impedance of said electrodes, and the conductivity ($\sigma_e$) of the conducting medium.

11. The device (400; 500; 600) of claim 9 or 10, wherein step b) comprises solving a system of equations of the following type:

$$\frac{I}{E} = f\left(\frac{L}{S_A * \left(Z_{elec} + Z_{int}\right) * \sigma_e}\right),$$

where I designates the current measured between the electrodes, L designates the distance between electrodes, $S_A$ designates the active surface area of the electrodes, $Z_{elec}$ designate the impedance of the electrodes, $Z_{int}$ designates the impedance between electrodes, $\sigma_e$ designates the conductivity of the conducting medium, and f designates an analytic function representative of the variation of conversion coefficient I/E according to ratio $\sigma_c/\sigma_e$, with $\sigma_c = L/(S_A * (Z_{elec} + Z_{int}))$.

12. A method of calibrating the electric field measurement device (400; 500; 600) of any of claims 1 to 11, comprising the steps of:

a) measuring the current (I) flowing between the two electrodes (105a, 105b; 605a) for at least two different values of said variable; and
b) deducing from said measurements the amplitude of the electric field (E) of the conducting medium, and at least one variable from among the impedance of said electrodes and the conductivity ($\sigma_e$) of the conducting medium.

13. The method of claim 12, wherein at step a), the current (I) flowing between the two electrodes (105a, 105b; 605a) is measured for at least three different values of said variable and, at step b), the amplitude of the electric field (E) in the conducting medium, the impedance of said electrodes, and the conductivity $(\sigma_e)$ of the conducting medium are deduced from said measurements.

Fig 1

Fig 2

Fig 3

Fig 4

Fig 5

Fig 6

## RÉFÉRENCES CITÉES DANS LA DESCRIPTION

### Documents brevets cités dans la description

- FR 2575296

- US 5440226 A